# EUROPÄISCHE PATENTSCHRIFT

(11) **EP 2 283 492 B1**
(45) Veröffentlichungstag und Bekanntmachung des Hinweises auf die Patenterteilung: **14.03.2012**
(21) Anmeldenummer: 09749740.8
(22) Anmeldetag: 13.05.2009
(51) Int. Cl.: H01B 17/26, G01R 15/14, H01R 13/533, H01R 13/52

(54) **ANORDNUNG MIT EINER GASDICHTEN MESSDURCHFÜHRUNG**
ARRANGEMENT COMPRISING A GAS-TIGHT MEASUREMENT BUSHING
ENSEMBLE COMPRENANT UNE TRAVERSÉE DE MESURE ÉTANCHE AUX GAZ

(30) Priorität: 19.05.2008 DE 102008024730
(43) Veröffentlichungstag der Anmeldung: 16.02.2011
(73) Patentinhaber: Siemens Aktiengesellschaft, 80333 München (DE)
(72) Erfinder: HELLWICH, Lars, 12437 Berlin (DE); MOELLER, Stefan, 13403 Berlin (DE); SEIDL, Dieter, 36037 Fulda (DE)
(86) Internationale Anmeldenummer: PCT/EP2009/055743
(87) Internationale Veröffentlichungsnummer: WO 2009/141250

(56) Entgegenhaltungen:
- EP-A- 1 326 080
- WO-A-93/10462
- DE-A1- 3 308 332
- GB-A- 967 702

## Beschreibung

Die Erfindung betrifft eine Anordnung mit einer gasdichten Messdurchführung aufweisend einen von einer Messader in Richtung einer Hauptachse durchsetzten Isolierkörper, welcher von einem Rahmen umgeben ist sowie mit einer gasisolierten Schaltanlage.

Eine derartige Anordnung ist beispielsweise aus der WO 93/10462 bekannt. Dort ist eine Hochspannungsmesseinrichtung beschrieben, bei welcher ein elektrischer Leiter zur Leitung eines Messsignals durch eine Wand eines Kapselungsgehäuses geführt ist. Der Leiter ist mit einem Isolator versehen, welcher mit der Wand gasdicht abschließt. Isolator und Leiter sind bei der bekannten Ausgestaltung selbsttragend ausgeführt und innerhalb eines Messgehäuses angeordnet. Bei der bekannten Anordnung ist zur Ausbildung eines gasdichten Übergangs zwischen Wand und Isolator eine Vielzahl von Arbeitsschritten nötig.

Der Patentspecification GB 967,702 ist eine Anordnung mit einem Isolierkörper entnehmbar, der von einer Messader durchsetzt ist. Der Isolierkörper ist von einem Rohrstück ummantelt. Die Offenlegungsschrift DE 33 08 332 A1 beschreibt eine Durchführung mit einem von einem Gießharzblock umfassten Leiterteil.

Es ist Aufgabe der Erfindung, eine Anordnung mit einer gasdichten Messdurchführung derart auszugestalten, dass eine vereinfachte Herstellung eines gasdichten Übergangs ermöglicht wird.

Erfindungsgemäß wird die Aufgabe bei einer Anordnung der eingangs genannten Art dadurch gelöst, dass der Rahmen ein erstes Rahmenteil und ein zweites Rahmenteil aufweist, welche unter Zwischenlage des Isolierkörpers gegeneinander verspannt sind und den Isolierkörper bezüglich der Hauptachse in Umfangrichtung überdecken und der Rahmen der Messdurchführung auf eine im Wesentlichen hohlzylindrische Gehäusebaugruppe der gasisolierten Schaltanlage mantelseitig aufgesetzt ist.

Durch eine Verwendung zweier Rahmenteile kann ein Rahmen gebildet werden, welcher den Isolierkörper um die Hauptachse herum umgreift und so den Isolierkörper vor aus radialen Richtungen einwirkenden Kräften schützt. Dabei ist es vorteilhaft, wenn der Rahmen den Isolierkörper längs der Hauptachse vollständig überdeckt. Es kann dazu vorgesehen sein, dass der Isolierkörper und die Rahmenteile als rotationssymmetrische Körper ausgeführt sind, deren Rotationsachsen Deckungsgleich zur Hauptachse ausgerichtet sind.

Mit einem Verspannen der Rahmenteile wird ein winkelstarrer Rahmen gebildet. Über diesen Rahmen kann die Messdurchführung positioniert werden. Durch ein Verspannen des Isolierkörpers zwischen den beiden Rahmenteilen ist eine stabilisierende Komponente gegeben. Da der Rahmen den Isolierkörper in Umfangsrichtung bedeckt, ist dieser nutzbar, um den Isolierkörper beispielsweise zur Anordnung der Messdurchführung an einem Kapselungsgehäuse einer gasisolierten Schaltanlage einzusetzen. Damit ist die Dimension der Messdurchführung im Wesentlichen durch die konstruktive Gestaltung des mehrteilig ausgebildeten Rahmens bestimmt. Dieser Rahmen kann unmittelbar mit dem Kapselungsgehäuse einer gasisolierten Schaltanlage verbunden werden. Über die Messdurchführung mit ihrem Isolierkörper und der den Isolierkörper durchsetzenden Messader kann beispielsweise ein Sammeln von Informationen im Innern des Kapselungsgehäuses vorgenommen werden und über die Messdurchführung zu einem außerhalb des Kapselungsgehäuse liegenden Ort übertragen werden. Die Dimension des Isolierkörpers richtet sich dabei im Wesentlichen nach dessen bei einem Betrieb zu erwartenden dielektrischen Beanspruchungen. Ein weiteres Kriterium bei der Dimensionierung des Isolierkörpers kann sein, dass dieser gegebenenfalls einer Differenzdruckbelastung ausgesetzt ist. Beispielsweise kann im Innern des Kapselungsgehäuses ein Druck herrschen, der von dem Druck des das Kapselungsgehäuse umgebenden Mediums verschieden ist. Insofern ist der Isolierkörper Teil der Kapselung, welche das Innere und das Äußere des Kapselungsgehäuses voneinander separiert.

Eine weitere vorteilhafte Ausgestaltung kann vorsehen, dass das erste Rahmenteil und das zweite Rahmenteil an voneinander abgewandten Seiten jeweils eine vorspringende Schulter aufweisen, die eine Relativbewegung des Isolierkörpers in Richtung der Hauptachse begrenzen.

Über die Schultern ist es vorteilhaft möglich, Kräfte zwischen erstem und zweitem Rahmenteil über den Isolierkörper zu übertragen. Damit ist es möglich, die beiden Rahmenteile winkelstarr mit dem Isolierkörper zu verbinden. Die vorspringenden Schultern können beispielsweise jeweils eine ringförmig umlaufende Kontaktierungsfläche ausbilden, welche auf gegengleichen Anlageflächen des Isolierkörpers zur Anlage kommen. Dabei sind die gegengleichen Anlageflächen vorteilhafterweise an voneinander abgewandten Seiten des Isolierkörpers befindlich. Um das Anliegen der vorspringenden Schultern zu verbessern, können auch Dämmmittel in einen Fügebereich eingebracht werden. Bei einer im Wesentlichen zylinderförmigen Außenkontur des Isolierkörpers ist es vorteilhaft, wenn nach einem Verbinden der beiden Rahmenteile eine gegengleiche Ausnehmung zwischen den beiden Rahmenteilen gebildet ist, so dass der Isolierkörper möglichst bündig mit dem Rahmen zur Anlage gelangt. Dabei ist es vorteilhaft, wenn der Isolierstoffkörper mantelseitig vollständig von dem Rahmen überdeckt ist, wobei ein Fügespalt zwischen dem ersten und dem zweiten Rahmenteil, beispielsweise mantelseitig umlaufend, gebildet ist. Durch den Ansatz von Schultern an dem ersten und dem zweiten Rahmenteil ist es auch vorteilhaft möglich, neben einem mantelseitigen Schutz des Isolierkörpers vor äußeren mechanischen Belastungen die Übergangspartien zwischen mantelseitigen Flächen und stirnseitigen Flächen zu überdecken und dortige Körperkanten des Isolierstoffkörpers ebenfalls vor äußeren mechanischen Beeinflussungen zu schützen. Dadurch ist eine Beschädigung des Isolierstoffkörpers nach erfolgter Verbindung mit dem Rahmen nur noch erschwert möglich. Dies ist von Vorteil, da durch eine Beschädigung das Isoliervermögen des Isolierkörpers beeinträchtigt werden kann.

Vorteilhaft kann weiter vorgesehen sein, dass zwischen zumindest einer Schulter und dem Isolierkörper ein Dichtelement angeordnet ist.

Ein Dichtelement zwischen einer vorspringenden Schulter und dem Isolierkörper kann eingesetzt werden, um einen fluiddichten Übergang zwischen einem oder beiden Rahmenteilen und dem Isolierkörper vorzusehen. Dazu kann vorgesehen sein, dass im Bereich einer Schulter eine Ausnehmung angeordnet ist, welche zur Aufnahme eines Dichtelementes geeignet ist. So kann beispielsweise in die Schulter eine um die Hauptachse umlaufende Ringnut eingebracht sein, in welcher ein O-Ring einlegbar ist. Eine entsprechende Ringnut kann auch in den Isolierkörper eingebracht werden oder sowohl im Isolierkörper als auch in einer vorspringenden Schulter vorgesehen sein. Durch das Dichtelement ist zum einen eine dämpfende Wirkung des Anliegens des Isolierkörpers an der vorspringenden Schulter gegeben, zum anderen kann eine dichtende Wirkung zwischen einem Rahmenteil und dem Isolierkörper hervorgerufen werden, so dass ein fluiddichter Verbund zwischen einem Rahmenteil und damit dem Rahmen sowie dem Isolierkörper gegeben ist. Damit ist es möglich, ebenso wie den Rahmen auch den Isolierkörper als Teil einer Kapselung eines Kapselungsgehäuses auszubilden. Als Dichtelement können beispielsweise elastomere Dichtelemente zum Einsatz gelangen, die über ihre fluiddichtende Wirkung hinaus auch eine dämpfende Wirkung haben, so dass bei einem Verkanten des Isolierkörpers innerhalb des Rahmens mechanische Spannungen aus der Gesamtkonstruktion entkoppelt werden können. Ebenso wie die vorspringenden Schultern unmittelbar oder auch mittelbar über ein Dicht- und/oder Dämmelement an einer Oberfläche des Isolierkörpers anliegend, kann auch vorgesehen sein, dass die mantelseitig den Isolierkörper umgebenden Bereiche des Rahmens eng an der oder den Mantelflächen des Isolierkörpers anliegen.

Eine weitere vorteilhafte Ausgestaltung kann vorsehen, dass sich an zumindest einer der Schultern in Richtung der Hauptachse eine Haube erhebt, welche über dem Isolierelement einen Anschlussraum begrenzt.

Durch einen Übergang einer Schulter in eine Haube kann oberhalb des Isolierkörpers an der Messdurchführung ein Volumen zur Verfügung gestellt werden, welches als Anschlussraum dient. In diesem Anschlussraum können beispielsweise Schnitte stellen zur Kontaktierung der Messader angeordnet sein. So ist es beispielsweise möglich, dass die Messader entsprechende Buchsen für Schraub- oder Steckanschlüsse oder andere Schnittstellen wie Löt-, Press- oder Schweißverbinder aufweist und so eine Verbindung der Messdurchführung mit Messgeräten erfolgen kann. Die Haube ist dazu mit einer Ausnehmung ausgestattet, um Messleitungen aus dem Anschlussraum nach au-βen zu führen. Vorteilhafterweise sind die Messleitungen gegenüber der Haube dichtend aus dem Anschlussraum ausgeleitet. Vorteilhafterweise ist die Ausnehmung in der Haube als Durchgangsbohrung ausgestaltet, wobei die Achsrichtung der Ausnehmung koaxial zur Hauptachse liegt.

Eine weitere Ausgestaltung kann vorteilhaft vorsehen, dass die Messader einen Anschlag aufweist, welcher abgedichtet an einer Fläche des Isolierkörpers anliegt.

Die Messader kann beispielsweise rotationssymmetrisch ausgebildet sein, wobei sich die Rotationsachse der Messader koaxial zur Hauptachse erstreckt und die Messader den Isolierkörper durchsetzt. Bei einer Verwendung eines rotationssymmetrischen Isolierkörpers ist es vorteilhaft, wenn die Messader auch koaxial zur Rotationsachse des Isolierkörpers ausgerichtet ist. Um eine Dichtung der Messader am Isolierkörper vorzusehen, kann vorgesehen sein, dass die Messader einen Anschlag beispielsweise in Form einer umlaufenden Schulter aufweist, welche der Ausbildung einer Dichtfläche dient. Dazu kann in den Anschlag beispielsweise eine Ringnut eingebracht sein, die der Aufnahme eines Dichtelementes, beispielsweise eine O-Ringes, dient. Der Anschlag kann dabei koaxial um die Rotationsachse der Messader umlaufen. Um eine Verspannwirkung zwischen Anschlag und zwischengelegtem Dichtelement zu erzeugen, kann beispielsweise vorgesehen sein, dass an dem dem Dichtelement zugewandten Ende der Messader eine Verspannkraft aufgebracht wird, welche den Anschlag gegen eine Fläche des Isolierkörpers zieht und diesen unter Zwischenlage des Dichtelementes zur Anlage bringt. Um eine Verspannkraft zu erzeugen kann die Messader mit einem Gewinde versehen sein, auf welches eine entsprechende Mutter aufschraubbar ist, so dass die Messader nach Art einer Schraube den Isolierkörper durchsetzt und die Messader von dem Isolierkörper getragen ist. Die Messader kann verschieden ausgeführt sein. So sind beispielsweise Messadern aus blankem elektrisch leitendem Material, Messadern mit Isolierbeschichtungen, Messadern mit Lichtwellenleitern usw. verwendbar.

Vorteilhafterweise kann weiter vorgesehen sein, dass auf eine im Wesentlichen hohlzylindrische Gehäusebaugruppe einer gasisolierten Schaltanlage mantelseitig der Rahmen der Messdurchführung gasdicht aufgesetzt ist.

Gasisolierte Schaltanlagen weisen in ihrem Innern elektrisch aktive Baugruppen wie beispielsweise Phasenleiter, Unterbrechereinheiten usw. auf. Innerhalb des Kapselungsgehäuses ist die Anordnung eines speziellen Isolierfluids, wie Schwefelhexafluorid, Stickstoff gereinigte atmosphärische Luft usw., vorgesehen, welches eine elektrische Isolierung der aktiven Baugruppen gegenüber dem Kapselungsgehäuse sicherstellt. Um ein Verflüchtigen des Isolierfluid zu vermeiden, ist das Kapselungsgehäuse als hermetisch geschlossenes System ausgebildet. Zur Erzeugung einer flexibel gestaltbaren Schaltanlage ist es vorgesehen, das Kapselungsgehäuse aus verschiedenen Gehäusebaugruppen zusammenzusetzen. Die Gehäusebaugruppen weisen dabei häufig eine hohlzylindrische Struktur auf. An diesen hohlzylindrischen Strukturen können mantelseitig relativ kleine Öffnungen vorgesehen werden, um den Rahmen der Messdurchführung mantelseitig aufzusetzen und in der Öffnung der Gehäusebaugruppe abzudichten. Dazu kann an einem der Rahmenteile eine eine Mantelfläche ausbildende Wandung an einem Stutzen vorgesehen sein, welcher abgedichtet mit der Gehäusebaugruppe in Kontakt steht und zumindest teilweise in die Öffnung hineinragt. Damit ist zumindest der Rahmenteil mit dem Stutzen über eine Dichtung zu dem Isolierkörper sowie über eine Dichtung zwischen dem Isolierkörper und der Messader Teil des Kapselungsgehäuses der Schaltanlage.

Je nach Bedarf können an einer einzigen oder auch mehrere Gehäusebaugruppen verteilt ein oder mehrere Messdurchführungen positioniert werden.

Vorteilhafterweise kann weiter vorgesehen sein, dass die im Wesentlichen hohlzylindrische Gehäusebaugruppe mit einem Isoliermedium befüllt ist, wobei das Isoliermedium von zumindest einer Leistungsstrombahn durchsetzt ist.

Durch eine Befüllung der Gehäusebaugruppe mit einem Isoliermedium wird eine elektrische Isolation von Leistungsstrombahnen, die Teil einer elektrisch aktiven Baugruppe sind, sichergestellt. Als Isoliermedium können beispielsweise gasförmige, flüssige oder feste Stoffe zum Einsatz gelangen. Als gasförmige Isoliermedien eignen sich insbesondere Schwefelhexafluorid, Stickstoff, Gemische mit diesen Gasen sowie weitere geeignete Medien. Als Isoliermedium kann beispielsweise auch ein Vakuum verwendet werden. Je nach Qualität des Vakuums sind Restgasanteile enthalten. Somit wird im Sinne dieser Anmeldung unter einem Fluid, insbesondere einem Gas, auch ein Vakuum verstanden. Als Isolierflüssigkeiten haben sich beispielsweise Isolieröle bewährt. Für die Verwendung von festen Isoliermedien eignen sich organische wie anorganische Stoffe, z. B. können Harze, Porzellane und Kunststoffe u. ä. zum Einsatz gelangen. Durch das Isoliermedium wird eine Ausbildung einer Kurzschlussstrombahn zwischen der Leistungsstrombahn und der Gehäusebaugruppe unterdrückt.

Weiter kann vorteilhaft vorgesehen sein, dass das Isoliermedium die Leistungsstrombahn positioniert.

Die Verwendung des Isoliermediums zur Lagefestlegung der Leistungsstrombahn ermöglicht zum einen eine elektrische Isolation von Leistungsstrombahn und Gehäusebaugruppe voneinander, zum anderen kann durch eine Übernahme von von der Leistungsstrombahn ausgehenden Kräfte durch das Isoliermedium eine Anzahl von zusätzlichen Haltevorrichtungen begrenzt werden. So ist es beispielsweise möglich, das Isoliermedium im Wesentlichen scheibenförmig auszugestalten und die Leistungsstrombahn durch diese scheibenförmige Struktur hindurchtreten zu lassen. Dabei kann die Scheibenform von einer idealen ebenen Scheibe abweichen und durchaus konische Strukturen aufweisen oder an ihrer Oberfläche wellenartige oder rippenartige Vorsprünge aufweisen. Das Isoliermedium ist beispielsweise als starrer Formkörper ausgeführt.

Vorteilhafterweise kann dabei vorgesehen sein, dass die Anzahl der Leistungsstrombahnen der Anzahl von an der im Wesentlichen hohlzylindrischen Gehäusebaugruppe angeordneten Rahmen entspricht.

Durch eine korrespondierende Anzahl von Leistungsstrombahnen und Rahmen ist eine Möglichkeit gegeben, beispielsweise jede Leistungsstrombahn separat zu überwachen. Dabei existiert jeweils eine Messdurchführung mit entsprechendem Rahmen, die einer bestimmten Leistungsstrombahn zugeordnet sind. Bei einer symmetrischen Verteilung der Leistungsstrombahn um eine Gehäuseachse kann eine entsprechend korrespondierende symmetrische Verteilung von Messdurchführungen auf der Außenmantelseite der Gehäusebaugruppe vorgenommen werden. Dadurch ist die Weglänge zwischen der einer Messdurchführung zugeordneten Leistungsstrombahn verringert. Somit sind Störungen durch benachbarte Leistungsstrombahnen vermieden.

Weiterhin kann vorteilhaft vorgesehen sein, dass die Messader einen Sondenkörper trägt.

Die Messader ist an dem Isolierkörper positioniert. Der Isolierkörper nebst Messader ist an dem Rahmen positioniert. Der Rahmen wiederum kann an einer Gehäusebaugruppe einer gasisolierten Schaltanlage positioniert werden. Über die Festlegung eines Montageplatzes für die Messdurchführung ergibt sich somit eine Möglichkeit, eine zur Aufnahme von Daten nötige Messsonde ebenfalls über die Messdurchführung zu positionieren. Die Messsonde kann beispielsweise tellerartig, rohrsektorartig oder anderweitig geformt sein. Über einen Bolzen, welcher beispielsweise mit der Messader verschraubt wird, ist eine Positionierung der Messsonde im Innern des Kapselungsgehäuses einer gasisolierten Schaltanlage möglich. Der Sondenkörper kann so problemlos positioniert werden und zusätzliche Führungen oder Halteeinrichtungen für den Sondenkörper sind nicht von Nöten. Mittels des Sondenkörpers ist es beispielsweise möglich, einen kapazitiven Spannungsteiler zu einer der Leistungsstrombahnen auszubilden und so ein Potential der Leistungsstrombahn zu ermitteln. Damit ist es beispielsweise möglich, qualitative oder quantitative Informationen über den Spannungszustand der Leistungsstrombahn zu beschaffen.

Im Folgenden wird die Erfindung anhand eines Ausführungsbeispiels in einer Zeichnung schematisch gezeigt und nachfolgend näher beschrieben.

Dabei zeigt die
- Figur 1: einen Schnitt durch eine Messdurchführung, die
- Figur 2: einen Schnitt durch eine Variante eines Isolierkörpers mit einer Variante einer Messader, die
- Figur 3: eine Draufsicht auf eine Gehäusebaugruppe mit mehreren Messdurchführungen.

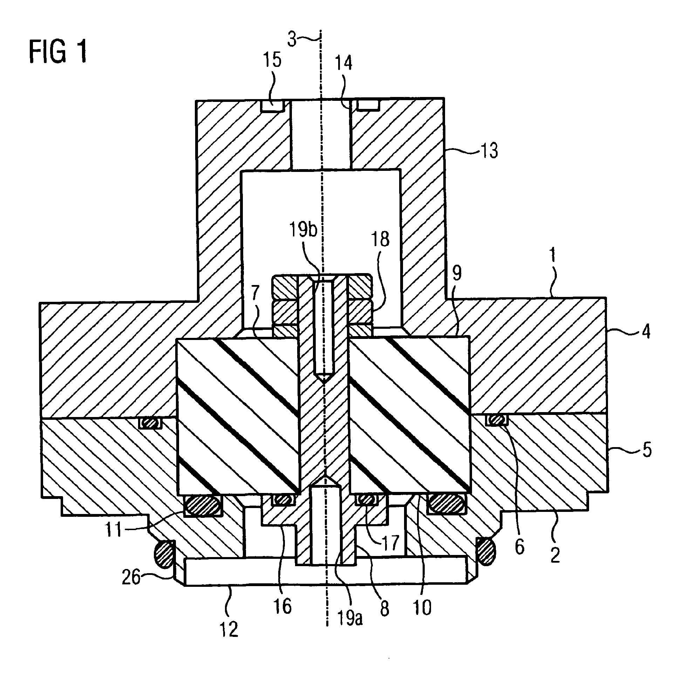

Die Figur 1 zeigt einen Schnitt durch eine Messdurchführung. Die Messdurchführung weist einen Rahmen auf, welcher ein erstes Rahmenteil 1 und ein zweites Rahmenteil 2 aufweist. Die beiden Rahmenteile 1, 2 sind rotationssymmetrisch ausgestaltet und koaxial zu einer Hauptachse 3 ausgerichtet. Die beiden Rahmenteile 1, 2 sind jeweils als rotationssymmetrische Körper ausgebildet, wobei die jeweilige Gesamtmantelfläche durch eine Mehrzahl von aufeinander folgenden zylindrischen Mantelflächen gebildet ist. Dabei stoßen die Mantelflächen, welche unterschiedliche Durchmesser umgreifen, teilweise unmittelbar aneinander, teilweise sind Übergangsabschnitte mit entsprechenden Abschrägungen, Auskehlungen o. ä. vorgesehen. Das erste Rahmenteil 1 weist einen ringförmigen Hauptsektor 4 auf. Das zweite Rahmenteil 2 weist ebenfalls einen ringförmigen Hauptsektor 5 auf. Die Hauptsektoren 4, 5 weisen zylindrische Mantelflächen auf, welche den maximalen Umfang des den ersten und zweiten Rahmenteil aufweisenden Rahmens der Messdurchführung begrenzen. Die beiden Hauptsektoren 4, 5 sind koaxial zur Hauptachse 3 ausgerichtet. Die einander zugewandten Flächen der Hauptsektoren 4, 5 sind kreisringförmig ausgestaltet und korrespondieren in ihren Dimensionen zueinander. Dadurch ist bei einem Aneinanderpressen von erstem Rahmenteil 1 und zweitem Rahmenteil 2 zwischen diesen kreisringförmigen Flächen ein Fügespalt des Rahmens gebildet. Zumindest in einer der kreisringförmigen Flächen ist eine erste Ringnut 6 eingebracht. In die erste Ringnut 6 ist ein O-Ring eingelegt, welcher eine dichtende und Anpresskräfte dämpfende Wirkung hervorruft. Zum Verspannen der beiden Rahmenteile 1, 2 gegeneinander sind die beiden Rahmenteile 1, 2 im Bereich der Hauptsektoren 4, 5 von entsprechenden Ausnehmungen durchsetzt, welche koaxial um die Hauptachse 3 verteilt angeordnet sind. Die Ausnehmungen können dann von entsprechenden Bolzen durchsetzt werden, die beispielsweise über Gewinde ein Verspannen der beiden Rahmenteile 1, 2 gegeneinander bewirken.

Im Innern des Rahmens ist ein Isolierkörper 7 angeordnet. Der Isolierkörper 7 weist eine zylinderförmige Außenkontur auf und ist von einer Messader 8 durchsetzt. Die Messader 8 ist zentrisch in den Isolierkörper 7 eingesetzt und tritt jeweils stirnseitig aus ihm heraus. Zur Positionierung des Isolierkörpers 7 im Innern des Rahmens weist das erste Rahmenteil eine vorspringende Schulter 9 auf. Ebenso weist das zweite Rahmenteil 2 eine vorspringende Schulter 10 auf. Die vorspringenden Schultern 9, 10 sind jeweils an die Hauptsektoren 4, 5 des ersten Rahmenteils 1 bzw. des zweiten Rahmenteils 2 angeformt. Dabei ist die Anformung derart ausgeführt, dass sich die vorspringenden Schultern 9, 10 jeweils auf der Innenmantelseite der hohlzylindrisch ausgeformten Hauptsektoren 4, 5 anschließen und zwar jeweils an den Seiten der Hauptsektoren 4, 5, welche in Richtung der Hauptachse 3 von dem Fügespalt zwischen erstem Rahmenteil 1 und zweitem Rahmenteil 2 abgewandt sind. Die vorspringenden Schultern 9, 10 sind dabei mit einer kreisringförmiger Struktur versehen, wobei die kreisringförmigen Strukturen der Schultern 9, 10 jeweils auf stirnseitigen Flächen des im Wesentlichen zylindrisch ausgeführten Isolierkörpers 7 zur Anlage kommen. Über die vorspringenden Schultern 9, 10 wird eine Anpresskraft auf den Isolierkörper 7 aufgebracht. Um eine Dichtwirkung zwischen dem zweiten Rahmenteil 2 und dem Isolierkörper 7 zu erzielen, ist in die vorspringende Schulter 10 des zweiten Rahmenteiles 2 eine umlaufende zweite Ringnut 11 eingebracht. In die zweite Ringnut 11 ist ein passender O-Ring eingelegt, der aus elastischem Material gebildet ist. Durch die Tiefe der zweiten Ringnut 11 wird ein Verpressen des in die zweite Ringnut 11 eingelegten O-Ringes begrenzt. Dadurch kommt der Isolierkörper 7 sowohl mit der vorspringenden Schulter 10 des zweiten Rahmenteils 2 als auch mit dem in die zweite Ringnut 11 eingelegten O-Ring in Kontakt. Somit ist eine gasdichte Verbindung zwischen dem zweiten Rahmenteil und dem Isolierkörper 7 geschaffen.

Neben dem Vorsehen einer zweiten Ringnut 11 zur Aufnahme eines Dichtelementes an dem zweiten Rahmenteil 2 kann eine derartige Ringnut auch in der vorspringenden Schulter 9 des ersten Rahmenteils 1 vorgesehen sein. Es kann jedoch auch vorgesehen sein, dass an dem Isolierkörper 7 geeignete Aufnahmen eingebracht werden, um ein Dichtelement zu positionieren. Beispielsweise können auch mantelseitig im Bereich des Fügespaltes zwischen erstem und/oder zweitem Rahmenteil 1, 2 und Isolierkörper 7 entsprechende Aufnahmen vorgesehen sein.

An der vorspringenden Schulter 10 des zweiten Rahmenteils 2 schließt sich ein Vorsprung 12 in Form eines Stutzens an, welcher sich ebenfalls koaxial zur Hauptachse 3 erstreckt und mantelseitig eine Dichtfläche 26 zur Verfügung stellt. Auf die Dichtfläche 26 ist ein O-Ring aufgesetzt, welcher eine Dichtwirkung zwischen dem Vorsprung 12 und damit zwischen dem zweiten Rahmenteil 2 und einer Gehäusewandung, in welche der Vorsprung 12 im montierten Zustand zumindest teilweise hineinragt, ermöglicht.

Die vorspringende Schulter 9 des ersten Rahmenteiles 1 geht in eine Haube 13 über, welche oberhalb einer der Stirnflächen des Isolierkörpers 7 einen Raum begrenzt. Im vorliegenden Falle ist die Haube 13 mit einer im Wesentlichen hohlzylindrischen Struktur versehen, die an ihrem von dem Isolierkörper 7 abgewandten Ende stirnseitig verschlossen ist, wobei in dem stirnseitigen Verschluss eine Leitungsöffnung 14 vorgesehen ist. Um auch größere Einbauten in den Raum einbringen zu können, kann vorgesehen sein, dass Teile der Haube 13 deckelartig ausgeführt sind. Somit ist auch im montierten Zustand der Messdurchführung ein Zugang zu dem Raum gegeben. Es kann beispielsweise der stirnseitige Verschluss als Deckel ausgebildet sein, welcher auch die Leitungsöffnung 14 aufweist. Die Leitungsöffnung 14 ist eine zylindrische Bohrung, welche koaxial zur Hauptachse 3 ausgerichtet ist. Je nach Bedarf können auch verschiedene Formgebungen der Haube 13 vorgesehen sein, so können beispielsweise konisch zulaufende Strukturen gewählt werden, um eine Ablagerung von unerwünschten Stoffen auf der äußeren Oberfläche des Rahmens zu reduzieren. Der von der Haube 13 begrenzte Raum kann beispielsweise als Anschlussraum dienen, um die stirnseitig aus dem Isolierkörper 7 herausragende Messader 8 zu kontaktieren. Beispielsweise können Schraubverbindungen, Steckbuchsen o. ä. innerhalb dieses Raumes angeordnet werden. Messleitungen sind entsprechend durch die Leitungsöffnung 14 nach außen geführt. Um eine entsprechende Abdichtung der Messleitungen zu gewährleisten, kann die Leitungsöffnung 14 abgedichtet verschlossen werden. Dazu ist im vorliegenden Falle eine dritte die Leitungsöffnung 14 konzentrisch umgebende Ringnut 15 nutzbar, in welche wiederum ein elastomerer O-Ring einbringbar ist, so dass ein abgedichtetes Verschließen auch der Leitungsöffnung 14 (ggf. unter Hindurchführung einer Messleitung) ermöglicht ist.

Die Messader 8 ist im Wesentlichen rotationssymmetrisch ausgebildet, wobei die Messader 8 den Isolierkörper 7 in Richtung der Hauptachse 3 durchsetzt, so dass die Messader außerhalb des Isolierkörpers 7 jeweils stirnseitig zugänglich ist. Die Messader 8 weist einen Anschlag 16 auf, welcher die Messader 8 an ihrem dem Vorsprung 12 zugewandten Ende ringförmig umgibt. Dadurch ist eine umlaufende Schulter gebildet, in welche eine vierte Ringnut 17 eingebracht ist. Die vierte Ringnut 17 ist dabei auf der zum Isolierkörper 7 zugewandten Seite in den Anschlag 16 eingebracht. Dort ist wiederum ein O-Ring aus elastischem Material eingebracht, welcher einen zwischen dem Anschlag 16 und einer stirnseitigen Fläche des Isolierkörpers 7 gebildeten Fügespalt abdichtet, so dass im Bereich des Durchtrittes der Messader 8 durch den Isolierkörper 7 ein fluiddichter Verschluss gegeben ist. Um den Anschlag 16 gegen den Isolierkörper 7 zu pressen, weist die Messader 8 am entgegengesetzten Ende einen Außengewindegang auf, auf welchen eine Mutter 18 aufschraubbar ist. Die Mutter 18 ist unter Zwischenlage einer Ringscheibe auf dem Außengewindegang der Messader 8 verschraubbar, so dass der Anschlag 16 gegen den Isolierkörper 7 gezogen wird und eine winkelstarre Verbindung zwischen Messader 8 und Isolierkörper 7 gegeben ist. Aus Sicherungsgründen kann eine so genannte Kontermutter zusätzlich aufgesetzt werden. An den stirnseitig aus dem Isolierkörper 7 herausragenden Enden sind jeweils Bohrungen 19a, 19b vorgesehen. Über die Bohrungen 19a, 19b können Anschlussstücke mit der Messader 8 verbunden werden. Über die Bohrung 19b, welche in den Raum unterhalb der Haube 13 ragt, ist es beispielsweise möglich, eine Messleitung mittels einer Steckverbindung zu kontaktieren. In die Bohrung 19a, welche an dem im Bereich des Vorsprunges 12 liegenden Ende der Messader 8 befindlich ist, ist ein Gewindegang eingebracht, so dass eine Messsonde eingeschraubt werden kann. Die Messsonde weist dazu einen Gewindebolzen auf, der mit einem Sondenkörper verschiedenster Form verbunden sein kann. Über die Bohrung 19b kann die Messsonde dann positioniert und gehalten werden. Die Messader 8 ist als winkelsteifer elektrisch leitender Körper ausgeführt.

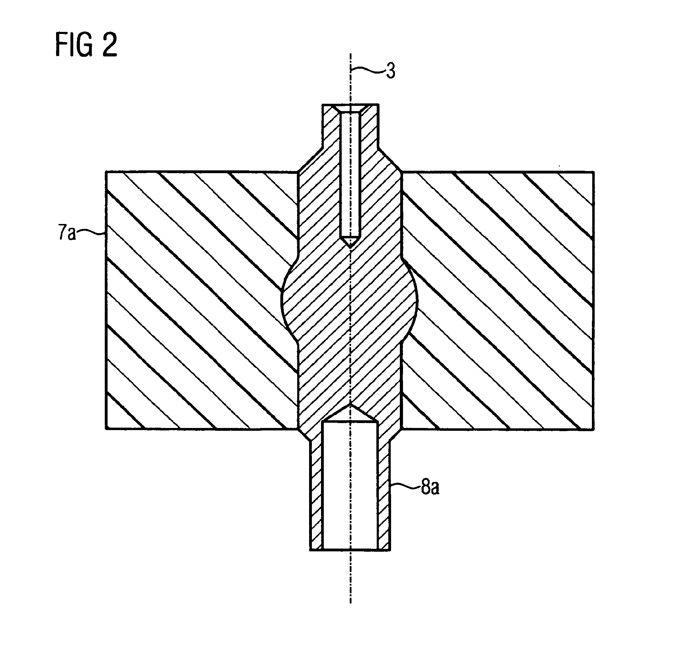

Die Figur 2 zeigt eine Variante eines Isolierkörpers 7a, welcher mit einer Variante einer Messader 8a verbunden und von dieser durchsetzt ist. Die äußeren Dimensionen der Variante des Isolierkörpers 7a entsprechen den in der Figur 1 gezeigten Isolierkörper 7. Lediglich für die Abdichtung und winkelstarre Positionierung der Variante der Messader 8a in der Variante des Isolierkörpers 7a ist eine alternative Form gewählt worden. Die Messader 8a weist in einem mittigen Bereich eine Ausbauchung auf, so dass ein axiales Verschieben in Richtung der Hauptachse 3 nach einem Verguss mit dem Isolierkörper nicht möglich ist. Somit ist durch den Verbund zwischen dem Isoliermaterial der Variante des Isolierkörpers 7a und der Oberfläche der Variante der Messader 8a durch einen Formschluss eine Positionierung zueinander gegeben. Zur Dichtung ist die Variante des Isolierkörpers 7a um die Variante der Messader 8a herum gegossen, so dass ein selbstdichtender Fügespalt zwischen der Variante der Messader 8a und der Variante des Isolierkörpers 7a gebildet ist. Somit sind separate Dichtelemente zwischen der Variante der Messader 8a und der Variante des Isolierkörpers 7a nicht erforderlich.

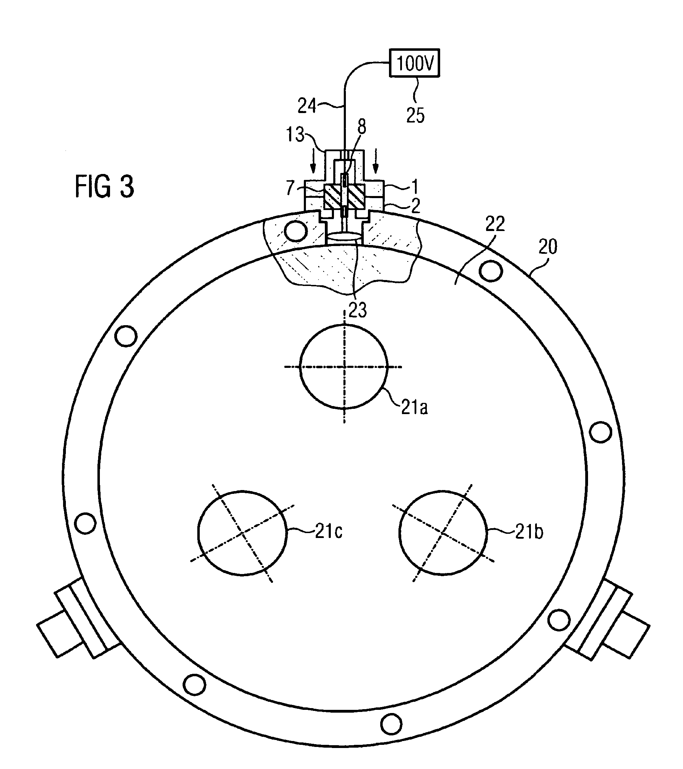

Die Figur 3 zeigt eine Verwendung mehrerer Messdurchführungen an einem im Wesentlichen hohlzylindrischen Gehäuseteil 20. Das Gehäuseteil 20 ist beispielsweise ein Abschnitt eines Kapselungsgehäuses einer gasisolierten Schaltanlage, die in ihrem Inneren eine erste, eine zweite sowie eine dritte Leistungsstrombahn 21a, 21b, 21c aufweist. Die Leistungsstrombahnen 21a, 21b, 21c weisen eine rotationssymmetrische Struktur auf, wobei die Rotationsachsen im vorliegenden Beispiel senkrecht zur Zeichenebene verlaufen. Ebenso ist eine Hohlzylinderachse des im Wesentlichen hohlzylindrischen Gehäuseteiles 20 senkrecht zu der Zeichenebene ausgerichtet. Um die Leistungsstrombahnen 21a, 21b, 21c zu positionieren, ist ein fester Isolierstoff 22 in das Gehäuseteil 20 eingebracht, wobei der feste Isolierstoff 22 mit dem Gehäuseteil sowie der ersten, der zweiten und der dritten Leistungsstrombahn 21a, 21b, 21c im Verbund steht. Somit ist ein Scheibenisolator gebildet, wie er in einer gasisolierten Schaltanlage einsetzbar ist. Dabei ist die Tiefe des Gehäuseteiles 20 geringer als der Durchmesser des Gehäuseteiles 20. Das hohlzylindrische Gehäuseteil 20 ist beispielsweise als metallischer Rahmen ausgeformt. Die Leistungsstrombahnen 21a, 21b, 21c wirken als Sammelschienenabschnitte.

Neben einem Einsatz von Messdurchführungen an einem Gehäuseteil 20, welches mit einem festen Isolierstoff ausgefüllt ist, kann auch vorgesehen sein, dass die Messdurchführungen auch an mit einem Isoliergas oder einer Isolierflüssigkeit gefüllten Gehäuseteilen zum Einsatz gelangen.

Jeder der Leistungsstrombahnen 21a, 21b, 21c ist einer Messdurchführung zugeordnet. Anhand der der ersten Leistungsstrombahn 21a zugeordneten Messdurchführung soll beispielhaft deren Montage und Wirkungsweise erläutert werden. Die der ersten Leistungsstrombahn 21a zugeordnete Messdurchführung ist freigeschnitten dargestellt. Die der zweiten Leistungsstrombahn 21b sowie der dritten Leistungsstrombahn 21c zugeordneten Messdurchführungen sind in einer seitlichen Ansicht dargestellt. Zu erkennen sind ein erstes Rahmenteil 1 sowie ein zweites Rahmenteil 2, die miteinander verspannt sind und im Innern einen Isolierkörper 7 aufnehmen. Der Isolierkörper 7 ist von der Messader 8 durchsetzt. An dem dem festen Isolierstoff 22 zugewandten Ende der Messader 8 ist ein Sondenkörper 23 gelagert. Der Sondenkörper 23 ist über einen Gewindebolzen in eine Bohrung 19b der Messader 8 eingeschraubt und winkelstarr mit der Messader 8 verbunden. Der Sondenkörper 23 ist im vorliegenden Beispiel als Kreisscheibe ausgeformt und dient als Feldsonde zur Erfassung von elektrischen Feldern.

Zum Anpressen des an dem Vorsprung 12 positionierten O-Ring sind im Bereich der Hauptsektoren 4, 5 des ersten und zweiten Rahmenteils 1, 2 in Richtung der Hauptachse 3 verlaufende Ausnehmungen vorgesehen, durch welche Bolzen greifen können. Mittels dieser Bolzen ist es möglich, den Rahmen gegen die äußere Mantelfläche des Gehäuseteiles 20 zu pressen, wobei der Vorsprung 12 in eine Ausnehmung in dem Gehäuseteil 20 hineinragt und unter Zwischenlage des die Mantelfläche des Vorsprunges 12 umgreifenden O-Ringes eine Dichtwirkung hervorruft. Damit ist es möglich, ein Austreten von Isoliermedien beispielsweise im Bereich des Sondenkörpers 23 aus dem Innern des Gehäuseteiles 20 zu verhindert. Dies ist insbesondere dann wichtig, wenn beispielsweise an das Gehäuseteil 20 weitere Gehäuseteile angrenzen, die beispielsweise fluide Isoliermedien begrenzen, so dass ein Verflüchtigen dieser fluiden Isoliermedien über die Messdurchführung verhindert ist.

An dem von der Haube 13 überspannten Ende der Messader 8 ist durch die Leitungsöffnung 14 eine Messleitung 24 in den Anschlussraum der Messdurchführung eingebracht. Über die Bohrung 19a, welche an dem Ende der Messader 8 angeordnet ist, welche von der Haube 13 überspannt ist, ist die Messleitung 24 mit der Messader 8 sowie mit dem Sondenkörper 23 verbunden. Die Messleitung ermöglicht eine Verbindung der Messader 8 mit einem Messgerät 25.

Über eine elektrische Feldstärke, die eine Leistungsstrombahn 21a, 21b, 21c bei einer Spannungsbeaufschlagung umgibt, können mittels einer Sammlung von Ladungsträgern auf dem Sondenkörper 23 Rückschlüsse über die Höhe einer elektrischen Spannung gezogen werden.

## Patentansprüche

1. Anordnung mit einer gasdichten Messdurchführung aufweisend einen von einer Messader (8, 8a) in Richtung einer Hauptachse (3) durchsetzten Isolierkörper (7, 7a), welcher von einem Rahmen umgeben ist sowie mit einer gasisolierten Schaltanlage,
**dadurch gekennzeichnet, dass**
der Rahmen ein erstes Rahmenteil (1) und ein zweites Rahmenteil (2) aufweist, welche unter Zwischenlage des Isolierkörpers (7, 7a) gegeneinander verspannt sind und den Isolierkörper (7, 7a) bezüglich der Hauptachse (3) in Umfangrichtung überdecken und der Rahmen der Messdurchführung auf eine im Wesentlichen hohlzylindrische Gehäusebaugruppe (20) der gasisolierten Schaltanlage mantelseitig aufgesetzt ist.

2. Anordnung mit einer gasdichten Messdurchführung nach Anspruch 1,
**dadurch gekennzeichnet, dass**
das erste Rahmenteil (1) und das zweite Rahmenteil (2) an voneinander abgewandten Seiten jeweils eine vorspringende Schulter (9, 10) aufweisen, die eine Relativbewegung des Isolierkörpers (7, 7a) in Richtung der Hauptachse (3) begrenzen.

3. Anordnung mit einer gasdichten Messdurchführung nach Anspruch 2,
**dadurch gekennzeichnet, dass**
zwischen zumindest einer Schulter (9, 10) und dem Isolierkörper (7, 7a) ein Dichtelement angeordnet ist.

4. Anordnung mit einer gasdichten Messdurchführung nach einem der Ansprüche 2 oder 3,
**dadurch gekennzeichnet, dass**
sich an zumindest einer der Schultern (9, 10) in Richtung der Hauptachse (3) eine Haube (13) erhebt, welche über dem Isolierelement (7, 7a) einen Anschlussraum begrenzt.

5. Anordnung mit einer gasdichten Messdurchführung nach einem der Ansprüche 1 bis 4,
**dadurch gekennzeichnet, dass**
die Messader (8, 8a) einen Anschlag (16) aufweist, welcher abgedichtet an einer Fläche des Isolierkörpers (7, 7a) anliegt.

6. Anordnung mit einer gasdichten Messdurchführung nach einem der Ansprüche 1 bis 5,
**dadurch gekennzeichnet, dass**
die im Wesentlichen hohlzylindrische Gehäusebaugruppe (20) mit einem Isoliermedium (22) befüllt ist, wobei das Isoliermedium von zumindest einer Leistungsstrombahn (21a, 21b, 21c) durchsetzt ist.

7. Anordnung mit einer gasdichten Messdurchführung nach Anspruch 6,
**dadurch gekennzeichnet, dass**
das Isoliermedium (22) die Leistungsstrombahn (21a, 21b, 21c) positioniert.

8. Anordnung mit einer gasdichten Messdurchführung nach einem der Ansprüche 6 bis 7,
**dadurch gekennzeichnet, dass**
die Anzahl der Leistungsstrombahnen (21a, 21b, 21c) der Anzahl von an der im Wesentlichen hohlzylindrischen Gehäusebaugruppe (20) angeordneten Rahmen entspricht.

9. Anordnung mit einer gasdichten Messdurchführung nach einem der Ansprüche 1 bis 8,
**dadurch gekennzeichnet, dass**
die Messader (8, 8a) einen Sondenkörper (23) trägt.

## Claims

1. Arrangement having a gastight measurement leadthrough, possessing an insulating body (7, 7a) which is penetrated by a measuring wire (8, 8a) in the direction of a major axis (3) and which is surrounded by a frame, and having a gas-insulated switchboard plant, **characterized in that** the frame has a first frame part (1) and a second frame part (2) which are braced with respect to one another, with the insulating body (7, 7a) interposed, and which cover the insulating body (7, 7a) in a circumferential direction in relation to the major axis (3), and the frame of the measurement leadthrough is placed onto an essentially hollow-cylindrical housing subassembly (20) of the gas-insulated switchboard plant on the surface area side.

2. Arrangement having a gastight measuring leadthrough according to Claim 1, **characterized in that** the first frame part (1) and the second frame part (2) have in each case a projecting shoulder (9, 10) on sides facing away from one another, said shoulders limiting a relative movement of the insulating body (7, 7a) in the direction of the major axis (3).

3. Arrangement having a gastight measurement leadthrough according to Claim 2, **characterized in that** a sealing element is arranged between at least one shoulder (9, 10) and the insulating body (7, 7a).

4. Arrangement having a gastight measurement leadthrough according to either one of Claims 2 and 3, **characterized in that** a hood (13) rises in the direction of the major axis (3) on at least one of the shoulders (9, 10) and delimits the connection space above the insulating element (7, 7a).

5. Arrangement having a gastight measurement leadthrough according to one of Claims 1 to 4, **characterized in that** the measuring wire (8, 8a) has a stop (16) which bears, sealed off, against a surface of the insulating body (7, 7a).

6. Arrangement having a gastight measurement leadthrough according to one of Claims 1 to 5, **characterized in that** the essentially hollow-cylindrical housing subassembly (20) is filled with an insulating medium (22), the insulating medium being penetrated by at least one power current path (21a, 21b, 21c).

7. Arrangement having a gastight measurement leadthrough according to Claim 6, **characterized in that** the insulating medium (22) positions the power current path (21a, 21b, 21c).

8. Arrangement having a gastight measurement leadthrough according to one of Claims 6 to 7, **characterized in that** the number of power current paths (21a, 21b, 21c) corresponds to the number of frames arranged on the essentially hollow-cylindrical housing subassembly (20).

9. Arrangement having a gastight measurement leadthrough according to one of Claims 1 to 8, **characterized in that** the measuring wire (8, 8a) carries a probe body (23).

## Revendications

1. Agencement comprenant un corps ( 7, 7a ) isolant, qui a une traversée de mesure étanche au gaz, qui est traversé par une veine ( 8, 8a ) de mesure dans la direction d'un axe ( 3 ) principal et qui est entouré d'un cadre, ainsi que comprenant une installation de distribution électrique isolée par du gaz,
**caractérisé en ce que**
le cadre comporte une première partie ( 1 ) et une deuxième partie ( 2 ), qui sont bloquées l'une par rapport à l'autre avec interposition du corps ( 7, 7a ) isolant et qui recouvrent le corps (7, 7a ) isolant dans la direction périphérique par rapport à l'axe ( 3 ) principal, et le cadre de la traversée de mesure est mis du côté de la surface latérale, sur un module ( 20 ) de boîtier, sensiblement cylindrique creux, de l'installation de distribution isolée par du gaz.

2. Agencement ayant une traversée de mesure étanche au gaz suivant la revendication 1,
**caractérisé en ce que**
la première partie ( 1 ) du cadre et la deuxième partie ( 2 ) du cadre ont, sur des côtés éloignés l'un de l'autre, respectivement un épaulement ( 9, 10 ) en saillie, qui limite un mouvement relatif du corps ( 7, 7a ) isolant dans la direction de l'axe ( 3 ) principal.

3. Agencement ayant une traversée de mesure étanche au gaz suivant la revendication 2,
**caractérisé en ce que**
un élément d'étanchéité est disposé entre au moins un épaulement ( 9, 10 ) et le corps ( 7, 7a ) isolant.

4. Agencement ayant une traversée de mesure étanche au gaz suivant l'une des revendications 2 ou 3,
caractérisé en ce
un capot ( 13 ), qui délimite un espace de connexion au-dessus de l'élément ( 7, 7a ) isolant, s'élève sur au moins l'un des épaulements ( 9, 10 ) dans la direction de l'axe ( 3 ) principal.

5. Agencement ayant une traversée de mesure étanche au gaz suivant l'une des revendications 1 à 4,
**caractérisé en ce que**
la veine ( 8, 8a ) de mesure comporte une butée ( 16 ), qui s'applique d'une manière étanche à une surface du corps ( 7, 7a ) isolant.

6. Agencement ayant une traversée de mesure étanche au gaz suivant l'une des revendications 1 à 5,
**caractérisé en ce que**
le module ( 20 ) de boîtier sensiblement cylindrique creux est rempli d'un milieu ( 22 ) isolant, le milieu isolant étant traversé par au moins une piste ( 21a, 21b, 21c ) de courant de puissance.

7. Agencement ayant une traversée de mesure étanche au gaz suivant la revendication 6,
**caractérisé en ce que**
le milieu ( 22 ) isolant positionne la piste ( 21a, 21b, 21c ) de courant de puissance.

8. Agencement ayant une traversée de mesure étanche au gaz suivant l'une des revendications 6 à 7,
**caractérisé en ce que**
le nombre des pistes ( 21a, 21b, 21c ) de courant de puissance correspond au nombre de cadres disposés dans le module ( 20 ) de boîtier sensiblement cylindrique creux.

9. Agencement ayant une traversée de mesure étanche au gaz suivant l'une des revendications 1 à 8,
**caractérisé en ce que**
la veine ( 8, 8a ) de mesure porte un corps ( 23 ) de sonde.
